(19) Europäisches Patentamt / European Patent Office / Office européen des brevets

(11) **EP 4 019 245 B1**

(12) **EUROPEAN PATENT SPECIFICATION**

(45) Date of publication and mention
of the grant of the patent:
**10.04.2024 Bulletin 2024/15**

(21) Application number: **20855160.6**

(22) Date of filing: **19.08.2020**

(51) International Patent Classification (IPC):
*C09J 7/22* (2018.01)     *C09J 7/30* (2018.01)
*C09J 133/08* (2006.01)    *B32B 27/00* (2006.01)
*B32B 27/18* (2006.01)     *B32B 27/30* (2006.01)
*C08K 5/12* (2006.01)      *B32B 7/022* (2019.01)
*C09J 201/00* (2006.01)    *H01L 21/683* (2006.01)
*H01L 21/301* (2006.01)

(52) Cooperative Patent Classification (CPC):
(C-Sets available)
**C09J 7/30; C09J 7/22; C09J 133/08;**
C08F 220/1802; C08F 220/1804; C08K 5/12;
C09J 2203/326; C09J 2301/312; C09J 2301/408;
C09J 2427/006; C09J 2433/00; C09J 2467/006;
H01L 21/6836; H01L 2221/68336          (Cont.)

(86) International application number:
**PCT/JP2020/031273**

(87) International publication number:
**WO 2021/033715 (25.02.2021 Gazette 2021/08)**

(54) **ELECTRONIC COMPONENT PROCESSING FILM AND ELECTRONIC COMPONENT PROCESSING METHOD**

VERARBEITUNGSFILM FÜR ELEKTRONISCHE KOMPONENTEN UND VERARBEITUNGSVERFAHREN FÜR ELEKTRONISCHE KOMPONENTEN

FILM DE TRAITEMENT DE COMPOSANT ÉLECTRONIQUE ET PROCÉDÉ DE TRAITEMENT DE COMPOSANT ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.08.2019 JP 2019152301**
**22.08.2019 JP 2019152302**

(43) Date of publication of application:
**29.06.2022 Bulletin 2022/26**

(73) Proprietor: **Resonac Corporation**
**Tokyo 105-7325 (JP)**

(72) Inventors:
• **NAKASHIMA, Saki**
**Tokyo 105-8518 (JP)**

• **YANAGITA, Yuki**
**Tokyo 105-8518 (JP)**

(74) Representative: **Berggren Oy**
**P.O. Box 16**
**Eteläinen Rautatiekatu 10A**
**00101 Helsinki (FI)**

(56) References cited:
**WO-A1-2017/150017     JP-A- 2001 019 916**
**JP-A- 2017 132 940**

(52) Cooperative Patent Classification (CPC): (Cont.)

C-Sets
C08F 220/1802, C08F 220/1804, C08F 220/44;
C08F 220/1804, C08F 220/44

**Description**

[Technical Field]

The present disclosure relates to an electronic component processing film and a method for processing an electronic component.

[Background Art]

In a method for producing electronic components such as semiconductor chips and ceramic condensers, a process of dicing a wafer disposed on an expandable film into chips of a desired size, and then picking the chips up by expanding the film to extend a space between the chips, has been conventionally performed.

Along with diversifying electronic component processing technologies of recent years, a technique for processing diced chips while being disposed on an expanded film has been considered. For this purpose, a film that can extend a space between the chips to more than a space required for picking them up has been studied. For example, International Publication No. 2018/216621 proposes a method for producing a semiconductor device including a process of extending a space between diced chips on a film, of not greater than 100 $\mu$m, to 300 $\mu$m or more; and a film used for the method.

[Summary of the Invention]

[Problem to be Solved by the Invention]

Addition of a plasticizer to a film is one of the techniques for improving an ability to expand a film. However, biological effects of phthalic acid esters such as bis(2-ethylhyxyl) phthalate, which are commonly used as a plasticizer, have been an issue of concern. Accordingly, development of a film that exhibits equivalent properties to that of a film to which a phthalic acid ester has been added, while using a different plasticizer instead of a phthalic acid ester, is desired. For example, WO2017/150017A1 describes a semiconductor processing sheet comprising a substrate and an adhesive layer, wherein the acrylic adhesion layer comprises di(2-ethylhexyl) terephthalate, and the vinyl chloride substrate layer comprises di(2-ethylhexyl) adipate. JP2017132940A describes adhesive tapes in which the adhesion layer and the substrate layer include bis(2-ethylhexyl)phthalate (DOP) and adhesive tapes in which the adhesion layer and the substrate layer include bis(2-ethylhexyl)terephthalate (DOTP).

In view of the foregoing, an embodiment of the present disclosure aims to provide an electronic component processing film with excellent expandability and biological affinity; and a method for processing an electronic component using the electronic component processing film.

In addition, the size of a chip is being reduced as electronic component devices become highly sophisticated and highly integrated. Therefore, dropping of a chip from a film has been an issue of concern as a rate of expansion of the film is increased.

In view of the foregoing, an embodiment of the present disclosure aims to provide an electronic component processing film with suppressed dropping of a chip when the film is expanded. Another embodiment of the present disclosure aims to provide a method for processing an electronic component using the electronic component processing film.

[Means for Solving the Problem]

The specific means for solving the problem includes the following embodiments.

An electronic component processing film, comprising an adhesion layer and a substrate layer, the adhesion layer comprising a terephthalic acid ester, and the substrate layer comprising a reaction product of an aliphatic dicarboxylic acid and a glycol.

A method for processing an electronic component, the method comprising expanding the electronic component processing film on which diced electronic components are disposed.

[Effect of the Invention]

According to an embodiment of the present disclosure, an electronic component processing film with excellent expandability and biological affinity is provided.

According to an embodiment of the present disclosure, an electronic component processing film with suppressed dropping of a chip when the film is expanded is provided.

According to an embodiment of the present disclosure, a method for processing an electronic component using these electronic component processing films is provided.

[Brief Explanation of the Drawing]

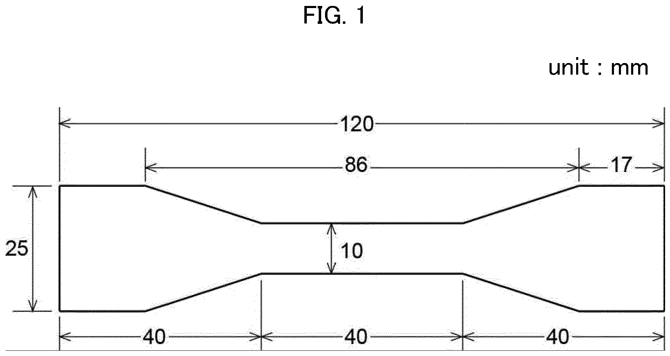

Fig. 1 is a drawing showing a shape of a test piece used in a tensile test.

[Embodiments for Implementing the Invention]

Embodiments for carrying out the present invention will now be described in detail.

In the following embodiments, constituent elements (including element steps and the like) of the embodiments are not essential, unless otherwise specified. Likewise, numerical values and ranges thereof are not intended to restrict the invention.

In the present disclosure, the definition of the term "step" includes not only an independent step which is distinguishable from another step, but also a step which is not clearly distinguishable from another step, as long as the purpose of the step is achieved.

In the present disclosure, any numerical range described using the expression "from * to" represents a range in which numerical values described before and after the "to" are included in the range as a minimum value and a maximum value, respectively.

In a numerical range described in stages, in the present disclosure, an upper limit value or a lower limit value described in one numerical range may be replaced with an upper limit value or a lower limit value in another numerical range described in stages. Further, in a numerical range described in the present disclosure, the upper limit value or the lower limit value in the numerical range may be replaced with a value shown in the Examples.

In the present disclosure, each component may include plural kinds of substances corresponding to the component. In a case in which plural kinds of substances corresponding to each component are present in a composition, the content ratio or content of each component refers to the total content ratio or content of the plural kinds of substances present in the composition, unless otherwise specified.

In the present disclosure, particles corresponding to each component may include plural kinds of particles. In a case in which plural kinds of particles corresponding to each component are present in a composition, the particle size of each component refers to the value of the particle size of a mixture of the plural kinds of particles present in the composition, unless otherwise specified.

<First Embodiment>

The first embodiment in the present disclosure is an electronic component processing film, comprising an adhesion layer and a substrate layer, the adhesion layer comprising a terephthalic acid ester, and the substrate layer comprising a reaction product of an aliphatic dicarboxylic acid and a glycol.

The electronic component processing film having the above configuration exhibits excellent biological affinity because of the use of terephthalic acid ester as a plasticizer. Further, expandability of the electronic component processing film having the above configuration is equivalent to that of an electronic component processing film in which phthalic acid ester is used as a plasticizer.

Further, the present inventors have found that the electronic component processing film having the above configuration exhibits superior temporal stability in adhesion as compared with an electronic component processing film using, as a plasticizer, phthalic acid ester or terephthalic acid ester in each of an adhesion layer and a substrate layer; and that the electronic component processing film having the above configuration exhibits superior adhesion between an adhesion layer and a substrate layer (interlayer adhesion) as compared with an electronic component processing film using, as a plasticizer, a reaction product of an aliphatic dicarboxylic acid and a glycol in each of an adhesion layer and a substrate layer.

(Adhesion layer)

The adhesion layer of the electronic component processing film is not specifically limited as long as it includes terephthalic acid ester.

The type of the terephthalic acid ester is not specifically limited, and examples thereof include a compound in which two alkyl groups (preferably alkyl groups having 5 to 10 carbon atoms) are bonded via ester groups to a benzene ring of terephthalic acid (phthalic acid dialkyl ester). Specific examples of the phthalic acid dialkyl ester include bis(2-ethylhexyl) terephthalate. The adhesion layer may include a single kind of terephthalic acid ester or two or more kinds thereof.

The content of the terephthalic acid ester in the adhesion layer is, for example, preferably from 5 parts by mass to 35 parts by mass; more preferably from 10 parts by mass to 20 parts by mass; further preferably from 15 parts by mass to 25 parts by mass, with respect to a solid component of an adhesive included in the adhesion layer.

When the content of the terephthalic acid ester with respect to 100 parts by mass of a solid component of an adhesive is 5 parts by mass or more (preferably from 15 parts by mass to 25 parts by mass), a sufficient temporal stability in adhesion tends to be achieved. When the content of the terephthalic acid ester with respect to 100 parts by mass of a solid component of an adhesive is 35 parts by mass or less, remaining of the adhesion layer to electronic components (adhesive residue) tends to be suppressed.

As necessary, the adhesion layer may include a plasticizer other than terephthalic acid ester. In that case, the proportion of the terephthalic acid ester to the total plasticizer is preferably 50% by mass or more, more preferably 70% by mass or more, further preferably 80% by mass or more.

When the adhesion layer includes a phthalic acid ester as a plasticizer, the proportion of the phthalic acid ester to the total plasticizer is preferably 20% by mass or less, more preferably 10% by mass or less, further preferably 5% by mass or less.

The adhesion layer preferably includes an adhesive. The type of the adhesive is not specifically limited, and may be selected known adhesives such as an acrylic adhesive, a rubber adhesive, a silicone adhesive and a urethane adhesive. From the viewpoint of stability in properties, the adhesion layer preferably includes an acrylic adhesive.

From the viewpoint of securing a certain degree of adhesion property, the acrylic adhesive is preferably a copolymer (acrylic copolymer) including a monomer with a low glass transition temperature (for example, -20°C or lower) as a copolymerization component. Examples of the acrylic monomer with a glass transition temperature of -20°C or lower include butyl acrylate, ethyl acrylate and 2-ethylhexyl acrylate. The glass transition temperature of the monomer refers to a glass transition temperature of a homopolymer obtained from the monomer.

From the viewpoint of suppressing the transfer of the adhesion layer to electronic components, the molecular weight of the acrylic copolymer is preferably greater. For example, the acrylic copolymer preferably has a weight average molecular weight of 1,000,000 or more. The upper limit of the molecular weight of the acrylic copolymer is not particularly limited. From the viewpoint of securing the adhesion, the upper limit of the molecular weight of the acrylic copolymer is preferably 5,000,000 or less.

As necessary, the adhesion layer may include a crosslinking agent. Examples of the crosslinking agent include isocyanate crosslinking agents, melamine crosslinking agents, peroxide crosslinking agents, metal alkoxide crosslinking agents, metal chelate crosslinking agents, metal salt crosslinking agents, carbodiimide crosslinking agents, oxazoline crosslinking agents, aziridine crosslinking agents and amine crosslinking agents. From the viewpoint of stable adhesion properties, isocyanate crosslinking agents are preferred. The adhesion layer may include a single kind of the crosslinking agent, or may include two or more kinds thereof.

The content of the crosslinking agent in the adhesion layer may be, for example, any of from 0.5 parts by mass to 20 parts by mass, from 1 parts by mass to 15 parts by mass, or from 2 parts by mass to 10 parts by mass, with respect to a total solid component of the adhesive in the adhesion layer.

As necessary, the adhesion layer may include a tackifier, a surfactant, a filler or the like.

From the viewpoint of facilitating the pickup of a chip, the adhesion layer may have an ability to lower a degree of adhesion by high-energy rays, such as ultraviolet rays or radioactive rays, or heat. For example, the degree of adhesion of the adhesion layer may be lowered by using an adhesive having an ability to cure by high-energy rays, such as ultraviolet rays or radioactive rays, or heat.

From the viewpoint of securing a sufficient adhesion with respect to a chip, the thickness of the adhesion layer is preferably 1 $\mu$m or more, more preferably 5 $\mu$m or more, further preferably 10 $\mu$m or more. From the viewpoint of economy, the thickness of the adhesion layer is preferably 100 $\mu$m or less, more preferably 50 $\mu$m or less.

As necessary, the adhesion layer may have a separator or the like on an outer surface thereof (a surface at a side opposite to a side facing the substrate layer).

(Substrate layer)

The substrate layer of the electronic component processing film is not specifically limited, as long as it includes a reaction product of an aliphatic dicarboxylic acid and a glycol.

Examples of the aliphatic dicarboxylic acid to react with a glycol include adipic acid, sebacic acid and axelaic acid. Examples of the glycol to react with an aliphatic dicarboxylic acid include 1,2-propanediol and butanediol. Among these, a reaction product of adipic acid and a glycol (adipic acid-based polyester) is preferred.

The molecular weight of the reaction product of an aliphatic dicarboxylic acid and a glycol is not specifically limited, and may be from 500 to 3,000, for example. The substrate layer may include a single kind of the reaction product of an aliphatic dicarboxylic acid and a glycol, or may include two or more kinds thereof.

The content of the reaction product of an aliphatic dicarboxylic acid and a glycol in the substrate layer is, for example, preferably from 30% by mass to 60% by mass, more preferably from 35% by mass to 55% by mass, further preferably from 40% by mass to 45% by mass, with respect to a total solid content of the substrate layer.

When the content of the reaction product of an aliphatic dicarboxylic acid and a glycol with respect to a total solid content of the substrate layer is 30% by mass or more, a sufficient degree of expandability tends to be achieved.

As necessary, the substrate layer may include a plasticizer other than a reaction product of an aliphatic dicarboxylic acid and a glycol. In that case, the proportion of the reaction product of an aliphatic dicarboxylic acid and a glycol with respect to the total plasticizer is preferably 50% by mass or more, more preferably 70% by mass or more, further preferably 80% by mass or more.

From the viewpoint of achieving a favorable expandability, the substrate layer preferably includes a thermoplastic resin.

Example of the thermoplastic resin include polyvinyl chloride, polyester, polyolefin, polyamide, polyimide and polyurethane. From the viewpoint of expandability, polyvinyl chloride is preferred.

From the viewpoint of visibility during processing, the substrate layer may include a colorant.

Examples of the colorant include dyes and pigments, and pigments are preferred from the viewpoint of durability.

The color of the colorant is preferably any color other than black, more preferably blue.

Specific examples of the colorant include alkali blue, disazo yellow, phthalocyanine blue, iron blue, ultramarine blue and cobalt blue.

When the colorant has a particulate shape, the maximum particle diameter of the colorant is preferably smaller than a thickness of the substrate layer when it is expanded. When the maximum particle diameter of the colorant is smaller than a thickness of the substrate layer when it is expanded, dropping of the colorant from the substrate layer during expansion is suppressed, which is advantageous in terms of maintenance of an electronic component processing appliance.

Specifically, for example, the maximum particle diameter of the colorant is preferably 25 $\mu$m or less, more preferably 20 $\mu$m or less, further preferably 10 $\mu$m or less.

In the present disclosure, the maximum particle diameter of the colorant refers to a maximum value of the maximum diameters of the particles obtained from the projection images (the length at which the diameter of the projection image is the largest) of the colorant particles (preferably by the number of 100 or more).

The content of the colorant in the substrate layer is, for example, preferably from 0.1% by mass to 2.0% by mass, more preferably from 0.2% by mass to 1.5% by mass, further preferably from 0.3% by mass to 1.0% by mass, with respect to the total solid content of the substrate layer.

From the viewpoint of securing a sufficient degree of strength, the thickness of the substrate layer is preferably 10 $\mu$m or more, more preferably 20 $\mu$m or more, further preferably 50 $\mu$m or more. From the viewpoint of securing a sufficient degree of expandability, the thickness of the substrate layer is preferably 500 $\mu$m or less, more preferably 200 $\mu$m or less, further preferably 150 $\mu$m or less.

As necessary, the outer surface of the substrate layer (a surface at a side opposite to a side facing an adhesion layer) may be subjected to a matting treatment, an antistatic treatment or the like.

The electronic component processing film in the present disclosure exhibits excellent temporal stability in adhesion. Specifically, the electronic component processing film maintains a favorable adhesion with respect to electronic components even after a long period of time from the preparation of the electronic component processing film. In an embodiment, the electronic component processing film may have a SUS adhesion (adhesion with respect to a stainless plate) 90 days after the preparation of 1 N/25 mm or more, 1.2 N/25 mm or more, or 1.5 N/25 mm or more.

From the viewpoint of facilitating the pickup of a chip, the electronic component processing film preferably has a SUS adhesion (when the film is subjected to a treatment to reduce the adhesion, the SUS adhesion after the treatment) is preferably 3.0 N/25 mm or less, more preferably 2.5 N/25 mm or less, further preferably 2.0 N/25 mm or less.

The measurement of the SUS adhesion is performed with TENSILON RTA-100 (Orientec Co., Ltd.) or a similar tester having a chuck and a 90° peeler.

As a SUS plate, a cold-rolled stainless steel 430 BA is used. Prior to the measurement, the SUS plate is subjected to heating for equalizing a surface tension, and ultrasonic cleaning with toluene for removing dirt. The conditions for the heating and the ultrasonic cleaning may be adjusted depending on a state of the SUS plate.

The electronic component processing film is cut into a size of 50 mm in width and 100 mm in length, a separator is removed if any, and the adhesion layer is attached to the SUS plate to prepare a test piece. The test piece is allowed to pass between a pair of rubber rolls at a rate of 2 m/minute, under 23°C while applying a pressure of 5880 N/m to press the adhesion layer. 30 minutes after the pressing, the test piece is cut into a size of 25 mm in width and 100 mm in length, and the electronic component processing film is peeled from the SUS plate in an orthogonal direction to the SUS plate (90° peeling) at a rate of 200 mm/minute. The peel force measured at the test is determined as the SUS adhesion.

From the viewpoint of achieving a sufficient expandability, the tensile strength of the electronic component processing film is preferably 10 MPa or more, more preferably 15 MPa or more, further preferably 20 MPa or more.

From the viewpoint of securing a sufficient strength, the tensile strength of the electronic component processing film is preferably 100 MPa or less, more preferably 50 MPa or less, further preferably 30 MPa or less.

From the viewpoint of achieving a sufficient expandability, the tensile elongation rate of the electronic component processing film is preferably 100% or more, more preferably 150% or more, further preferably 200% or more.

From the viewpoint of securing a sufficient strength, the tensile elongation rate of the electronic component processing film is preferably 1,000% or less, more preferably 700% or less, further preferably 500% or less.

Examples of the method for adjusting the tensile strength and the tensile elongation rate of the electronic component processing film include adjusting the thickness of the substrate layer and selecting the type or the amount of the component (such as a thermoplastic resin or a plasticizer) included in the substrate layer.

The measurement of the tensile strength and the tensile elongation rate of the electronic component processing film is performed with TENSILON RTA-100 (Orientec Co., Ltd.) or a similar tensile tester having a chuck and a 180° peeler.

For the measurement, a test piece having a shape as shown in Fig. 1 is prepared from the electronic component processing film. The tensile test is performed by chucking the edges of the test piece with a tester, under an environment of 23±5°C at a tensile rate of 500 mm/minute. When the electronic component processing film has a separator on the adhesion layer, the test is performed without the separator.

The tensile strength is calculated from an average thickness (0.100 mm) and a width (10 mm) of the test piece prior to the test, and a maximum load (N) before the test piece breaks, according to the following formula.

The tensile elongation rate is calculated from a distance between reference points A (length of a portion of the test piece with a width of 10 mm: 40 mm) prior to the test, and a distance between reference points B when the test piece breaks, according to the following formula.

$$\text{Tensile strength (Mpa)} = \frac{\text{Maximum load before test piece breaks (N)}}{\text{Average thickness (mm) x Width (mm)}}$$

$$\text{Tensile elongation rate (\%)} = \frac{\text{Distance between reference points B - Distance between reference points A}}{\text{Distance between reference points A (40 mm)}} \times 100$$

The electronic component processing film according to the first embodiment may satisfy the conditions as mentioned in connection with the electronic component processing film according to the second embodiment or the electronic component processing film according to the third embodiment.

<Second Embodiment>

The second embodiment in the present disclosure is an electronic component processing film, comprising an adhesion layer and a substrate layer, and having a tackiness of 40 gf or more and a SUS adhesion of 1.1 N/25 mm or more.

The present inventors have found that dropping of a chip from an electronic component processing film when it is expanded cannot be sufficiently suppressed by merely having a high degree of adhesion or merely having a high degree of tackiness with respect to electronic components. Further, the present inventors have found that dropping of a chip can be effectively suppressed when the electronic component processing film has a tackiness of 40 gf or more and a SUS adhesion of 1.1 N/25 mm or more.

In the present disclosure, the tackiness of the electronic component processing film is measured by the following method.

The measurement of the tackiness is performed with a probe tackiness tester TAC-II (RHESCA Co., Ltd.) or a similar tackiness tester.

The electronic component processing film is cut into a size of 20 mm in width and 100 mm in length, a separator is removed if any, and is set to a tackiness tester such that the adhesion layer is positioned upward.

The procedures of moving the probe downward, applying a pressure, and moving the probe upward are performed under the conditions of 23±5°C, descending rate of probe of 120 mm/minute, load for pressing of 10 gf, time for pressing of 10 seconds, and ascending rate of probe of 600 mm/minute.

From the viewpoint of suppressing the dropping of a chip, the tackiness of the electronic component processing film is preferably 45 gf or more, more preferably 50 gf or more, further preferably 70 gf or more.

From the viewpoint of facilitating the pickup of a chip, the tackiness of the electronic component processing film is preferably 300 gf or less, more preferably 250 gf or less, further preferably 200 gf or less.

Examples of the method for adjusting the tackiness of the electronic component processing film include adjusting the thickness of the adhesion layer and selecting the type or the amount of the component (such as an adhesive, a plasticizer or a crosslinking agent) included in the adhesion layer.

From the viewpoint of achieving a sufficient adhesion with respect to electronic components, the electronic component processing film preferably has a SUS adhesion (adhesion with respect to a stainless plate) of 1.2 N/25 mm or more, more preferably 1.3 N/25 mm or more, further preferably 1.5 N/25 mm or more.

From the viewpoint of facilitating the pickup of a chip, the electronic component processing film preferably has a SUS adhesion (when the film is subjected to a treatment to reduce the adhesion, the SUS adhesion after the treatment) is preferably 3.0 N/25 mm or less, more preferably 2.5 N/25 mm or less, further preferably 2.0 N/25 mm or less.

Examples of the method for adjusting the SUS adhesion of the electronic component processing film include adjusting the thickness of the adhesion layer and selecting the type or the amount of the component (such as an adhesive, a plasticizer or a crosslinking agent) included in the adhesion layer.

The SUS adhesion is measured in the same manner as the SUS adhesion of the electronic component processing film according to the first embodiment.

From the viewpoint of achieving a sufficient expandability, the tensile strength of the electronic component processing film is preferably 10 MPa or more, more preferably 15 MPa or more, further preferably 20 MPa or more.

From the viewpoint of securing a sufficient strength, the tensile strength of the electronic component processing film is preferably 100 MPa or less, more preferably 50 MPa or less, further preferably 30 MPa or less.

From the viewpoint of achieving a sufficient expandability, the tensile elongation rate of the electronic component processing film is preferably 100% or more, more preferably 150% or more, further preferably 200% or more.

From the viewpoint of securing a sufficient strength, the tensile elongation rate of the electronic component processing film is preferably 1,000% or less, more preferably 700% or less, further preferably 500% or less.

Examples of the method for adjusting the tensile strength and the tensile elongation rate of the electronic component processing film include adjusting the thickness of the substrate layer and selecting the type or the amount of the component (such as a thermoplastic resin or a plasticizer) included in the substrate layer.

The tensile strength and the tensile elongation rate are measured in the same manner as the tensile strength and the tensile elongation rate of the electronic component processing film of the first embodiment.

(Adhesion layer)

The adhesion layer of the electronic component processing film preferably includes an adhesive. The type of the adhesive is not specifically limited, and may be selected known adhesives such as an acrylic adhesive, a rubber adhesive, a silicone adhesive and a urethane adhesive. From the viewpoint of stability, the adhesion layer preferably includes an acrylic adhesive. The adhesive may be dissolved or dispersed in an organic solvent, water or the like.

As the acrylic adhesion, an acrylic adhesive that may be included in the adhesion layer of the electronic component processing film according to the first embodiment may be used.

The adhesion layer includes a plasticizer. By including a plasticizer in the adhesion layer, expandability of the electronic component processing film tends to improve.

From the viewpoint of biological affinity, the adhesion layer includes terephthalic acid ester. The adhesion layer may include a single kind of plasticizer, or may include two or more kinds thereof.

As the terephthalic acid ester, a terephthalic acid ester included in the adhesion layer of the electronic component processing film of the first embodiment is used.

When the adhesion layer includes a terephthalic acid ester, the proportion of the terephthalic acid ester to the total plasticizer is preferably 50% by mass or more, more preferably 70% by mass or more, further preferably 80% by mass or more.

The content of the plasticizer in the adhesion layer is, for example, preferably from 5% by mass to 35% by mass, more preferably from 10% by mass to 30% by mass, further preferably from 15% by mass to 25% by mass, with respect to a total solid content of the adhesion layer.

When the adhesion layer includes a plasticizer, expandability of the electronic component processing film tends to improve. Meanwhile, when the content of the plasticizer is 35 parts by mass or less with respect to 100 parts by mass of a solid component of the adhesive, remaining of the adhesion layer to electronic components (adhesive residue) tends to be suppressed. Further, a decrease in the SUS adhesion and a decrease in the tackiness due to a reduced amount of the adhesive in the adhesion layer tends to be suppressed.

As necessary, the adhesion layer may include a crosslinking agent. As the crosslinking agent, a crosslinking agent that may be used in the adhesion layer of the electronic component processing film according to the first embodiment may be used. From the viewpoint of stable adhesion properties, isocyanate crosslinking agents are preferred. The adhesion layer may include a single kind of crosslinking agent, or may include two or more kinds thereof.

The content of the crosslinking agent in the adhesion layer is, for example, preferably from 0.5 % by mass to 20% by mass, more preferably from 1% by mass to 15% by mass, further preferably from 2% by mass to 10% by mass, with respect to a total solid content of the adhesion layer.

As necessary, the adhesion layer may include a component other than an adhesive, a plasticizer and a crosslinking agent. For example, the adhesion layer may include a tackifier, a surfactant, a filler or the like.

From the viewpoint of facilitating the pickup of a chip, the adhesion layer may have an ability to lower a degree of adhesion by high-energy rays, such as ultraviolet rays or radioactive rays, or heat. For example, the degree of adhesion of the adhesion layer may be lowered by using an adhesive having an ability to cure by high-energy rays, such as ultraviolet rays or radioactive rays, or heat.

From the viewpoint of securing a sufficient adhesion with respect to a chip, the thickness of the adhesion layer is preferably 1 $\mu$m or more, more preferably 5 $\mu$m or more, further preferably 10 $\mu$m or more. From the viewpoint of economy, the thickness of the adhesion layer is preferably 100 $\mu$m or less, more preferably 50 $\mu$m or less.

As necessary, the adhesion layer may have a separator or the like on an outer surface thereof (a surface at a side opposite to a side facing the substrate layer).

(Substrate layer)

The substrate layer of the electronic component processing film preferably includes a thermoplastic resin.

Example of the thermoplastic resin include polyvinyl chloride, polyester, polyolefin, polyamide, polyimide and polyurethane. From the viewpoint of expandability, polyvinyl chloride is preferred.

The substrate layer includes a plasticizer. When the substrate layer includes a plasticizer, expandability of the electronic component processing film tends to improve.

The content of the plasticizer in the substrate layer is, for example, preferably from 30% by mass to 60% by mass, more preferably from 35% by mass to 55% by mass, further preferably from 40% by mass to 45% by mass, with respect to a total solid content of the substrate layer.

When the content of the plasticizer with respect to a total solid content of the substrate layer is 30% by mass or more, a sufficient degree of expandability tends to be achieved. When the content of the plasticizer with respect to a total solid content of the substrate layer is 60% by mass or less, a sufficient degree of strength tends to be achieved.

From the viewpoint of biological affinity, the substrate layer includes a plasticizer other than phthalic acid ester, which is a reaction product of an aliphatic dicarboxylic acid and a glycol. The substrate layer may include a single kind of a plasticizer, or may include a two or more kinds thereof.

As the reaction product of an aliphatic dicarboxylic acid and a glycol, a reaction product of an aliphatic dicarboxylic acid and a glycol included in the substrate layer of the electronic component processing film according to the first embodiment is used.

When the substrate layer includes a reaction product of an aliphatic dicarboxylic acid and a glycol as a plasticizer, the proportion of the reaction product of an aliphatic dicarboxylic acid and a glycol with respect to the total plasticizer is preferably 50% by mass or more, more preferably 70% by mass or more, further preferably 80% by mass or more.

From the viewpoint of visibility during processing, the substrate layer may include a colorant. As the colorant, a colorant that may be included in the substrate layer of the electronic component processing film according to the first embodiment may be used.

The content of the colorant in the substrate layer is, for example, preferably from 0.1% by mass to 2.0% by mass, more preferably from 0.2% by mass to 1.5% by mass, further preferably from 0.3% by mass to 1.0% by mass, with respect to the total solid content of the substrate layer.

From the viewpoint of securing a sufficient degree of strength, the thickness of the substrate layer is preferably 10 $\mu$m or more, more preferably 20 $\mu$m or more, further preferably 50 $\mu$m or more. From the viewpoint of securing a sufficient degree of expandability, the thickness of the substrate layer is preferably 500 $\mu$m or less, more preferably 200 $\mu$m or less, further preferably 150 $\mu$m or less.

As necessary, the outer surface (a surface at a side opposite to a side facing an adhesion layer) may be subjected to a matting treatment, an antistatic treatment or the like.

The electronic component processing film according to the second embodiment may satisfy the conditions mentioned in the electronic component processing film according to the first embodiment or the electronic component processing film according to the third embodiment.

<Third Embodiment>

The third embodiment according to the present disclosure is an electronic component processing film, comprising an adhesion layer and a substrate layer, the adhesion layer comprising a terephthalic acid ester, and the substrate layer comprising a reaction product of an aliphatic dicarboxylic acid and a glycol, the adhesion layer having a thickness of 12 $\mu$m or more.

In the electronic component processing film having the above configuration, the adhesion layer has an excellent ability to embed a chip owing to its thickness. Therefore, dropping of a chip can be suppressed even in a case of processing small-sized chips with a small portion to contact the adhesion layer, which are used increasingly in recent days, in addition to the chips of conventional sizes.

Further, the present inventors have found that the electronic component processing film having the above configuration can suppress dropping of a chip even when the film is expanded at a high rate, irrespective of the size of the chip.

The thickness of the adhesion layer may be 15 $\mu$m or more, or may be 20 $\mu$m or more, as long as it is 12 $\mu$m or more. From the viewpoint of economy, the thickness of the adhesion layer is preferably 100 $\mu$m or less, more preferably 50 $\mu$m or less.

The details and preferred embodiments of the electronic component processing film, other than the thickness of the adhesion layer, are the same as the details and preferred embodiments of the electronic component processing film according to the first embodiment or the electronic component processing film according to the second embodiment.

The electronic component processing film according to the third embodiment may satisfy the conditions as described in connection with the electronic component processing film according to the first embodiment or the electronic component processing film according to the second embodiment.

<Method for processing electronic component>

The method for processing electronic component according to the present disclosure includes expanding the electronic component processing film as mentioned above, on which diced electronic components are disposed (expanding step).

In the method, the electronic components disposed on the electronic component processing film may be diced on the electronic component processing film, or may be diced prior to being disposed on the electronic component processing film.

The method for disposing the electronic components, which have been diced prior to being disposed on the electronic component processing film, on the electronic component processing film may be, for example, a method including dicing the electronic components on a different film, attaching the adhesion layer of the electronic component processing film to the diced electronic components, and transferring the electronic components to the electronic component processing film.

The expansion rate of the electronic component processing film in the expansion step is not specifically limited, and may be selected depending on the type of the processing to be performed after the expansion, or the like. For example, the expansion rate may be 1.2 or more, or may be 1.5 or more.

The expansion rate is a value calculated by the following formula.

$$\text{Expansion rate} = \text{Maximum diameter of electronic component processing film after expansion} / \text{Maximum diameter of electronic component processing film before expansion}$$

The distance between the electronic components after the expansion (the minimum distance when the distance is not constant) is not specifically limited, and may be selected depending on the type of the processing to be performed after the expansion. For example, the distance between the electronic components may be any of 100 $\mu$m or more, 200 $\mu$m or more, or 300 $\mu$m or more.

As necessary, the method may include processing the electronic components on the electronic component processing film after the expansion (such as encapsulation or thermal treatment).

After the expansion and the optional processing if any, the electronic components are picked up from the electronic component processing film. The method for the pickup is not specifically limited, and may be performed by a known process.

Prior to the pickup, a process for reducing the adhesion of the adhesion layer (such as ultraviolet irradiation or thermal treatment) may be performed.

The type of the electronic components used in the method is not specifically limited, and examples thereof include semiconductor chips of various kinds and ceramic condensers.

[Examples]

In the following, the embodiments are explained in more details by referring to the Examples, while the embodiments are not limited to the Examples. Unless otherwise noted, reagents are used as the chemicals.

<First Embodiment>

(Preparation of adhesive composition)

The materials shown in the following Table 1 were mixed at the amounts shown in Table 1 (parts by mass), thereby preparing a composition for adhesion layer.
As the substrate, the materials shown in Table 1 were used. The amount of the adhesive shown in Table 1 is the amount of the solid component included in the adhesive.
The details of the materials shown in Table 1 are as follows.

Adhesive: acrylic adhesive (Tohpe Corporation, XE-2644, solid content: 12% by mass, a copolymer of butyl acrylate by 80 to 90% by mass and acrylonitrile by 10 to 20% by mass)
Plasticizer 1: bis(2-ethylhexyl) terephthalate, Adeka Corporation, D-810, solid content: 100% by mass
Plasticizer 2: bis(2-ethylhexyl) phthalate, Godo Co., Ltd., DOP, solid content: 100% by mass
Plasticizer 3: adipic acid-based polyester (Mw: approximately 2,000), Adeka Corporation, P-200, solid content: 100% by mass
Crosslinking agent: polyfunctional isocyanate (Nippon Polyurethane Industry Co., Ltd., CORONATE L, solid content: 75% by mass
Solvent: methyl ethyl ketone
Substrate 1: polyvinyl chloride film (thickness: 80 $\mu$m), including bis(2-ethylhexyl) terephthalate by 39% by mass and a pigment (phthalocyanine blue, maximum particle diameter: 10 $\mu$m) by 0.5% by mass with respect to the total substrate
Substrate 2: polyvinyl chloride film (thickness: 80 $\mu$m), including bis(2-ethylhexyl) phthalate by 38% by mass and a pigment (ultramarine blue, maximum particle diameter: 30 $\mu$m) by 0.5% by mass with respect to the total substrate
Substrate 3: polyvinyl chloride film (thickness: 80 $\mu$m), including adipic acid-based polyester (Mw: approximately 2,000) by 44% by mass and a pigment (phthalocyanine blue, maximum particle diameter: 10 $\mu$m) by 0.5% by mass with respect to the total substrate

(Preparation of electronic component processing film)

To a surface of a polyethylene terephthalate film (thickness: 38 $\mu$m), treated with a releasing agent, the composition for adhesion layer was applied so as to form an adhesion layer with a thickness in a dried state shown in Table 1, and dried.
Subsequently, the adhesion-layer side of the polyethylene terephthalate film was attached to a substrate at room temperature (25°C), and the adhesion layer was transferred to the substrate by applying a pressure with a rubber roll, thereby preparing an electronic component processing film having a substrate layer and an adhesion layer for Example 1-1 and Comparative Examples 1-1 to 1-3.

(Evaluation of expandability)

The tensile strength and tensile elongation rate of the electronic component processing film of Example 1-1 measured by the methods as described above were 26.5 MPa and 339%, respectively. The tensile strength and tensile elongation rate of the electronic component processing film of Comparative Example 1-1 measured by the methods as described above were 27.5 MPa and 347%, respectively.
From these results, it was found that the expandability of the electronic component processing film of Example 1-1 was equivalent to that of the electronic component processing film of Comparative Example 1-1, including phthalic acid ester in each of the adhesion layer and the substrate layer.

(Evaluation of temporal stability in adhesion)

The SUS adhesion of the electronic component processing film was measured by the method as described above. The measurement was performed at 2 days and at 90 days after the preparation of the electronic component processing film, respectively. The change rate in the SUS adhesion was calculated by the following formula and evaluated by the following criteria. The results are shown in Table 1.

A: The change rate in SUS adhesion is within ±20%
B: The change rate in SUS adhesion is outside ±20%

(Evaluation of interlayer adhesion)

The SUS adhesion of the electronic component processing film was measured by the method as described above. The state of a surface of the SUS plate and the electronic component processing film was visually observed, and was evaluated by the following criteria. The results are shown in Table 1.

A: The adhesion layer and the substrate do not separate from each other, and the adhesion layer does not transfer to the SUS plate.
B: The adhesion layer and the substrate separate from each other, and the adhesion layer transfers to the SUS plate.

(Evaluation of pigment ejection)

The electronic component processing film was expanded on an expansion apparatus at 60°C, such that the maximum diameter after the expansion was twice as large as the original maximum diameter. Thereafter, in order to see if a pigment was ejected from the substrate layer, a surface of the substrate layer, which had been contacting the expansion apparatus, was wiped with a white cloth three times, and the existence or non-existence of the pigment on the white cloth was determined with a microscope. The results are evaluated by the following criteria and shown in Table 1.

A: the pigment does not attach to the white cloth.
B: the pigment attaches to the white cloth.

[Table 1]

| | Composition for adhesion layer | | | | | | | | SUS adhesion [N/25mm] | | | Interlayer adhesion | Pigment residue |
|---|---|---|---|---|---|---|---|---|---|---|---|---|---|
| | Adhesive | Plasticizer | | | Crosslinking agent | Solvent | Adhesion layer thickness [µm] | Substrate | 2 days after | 90 days after | Evaluation | | |
| | | 1 | 2 | 3 | | | | | | | | | |
| Example 1-1 | 100 | 20 | 0 | 0 | 2 | 10 | 20 | 3 | 1.373 | 1.545 | A | A | A |
| Comparative Example 1-1 | 100 | 0 | 30 | 0 | 2 | 10 | 20 | 2 | 1.643 | 1.235 | B | A | B |
| Comparative Example 1-2 | 100 | 0 | 0 | 20 | 2 | 10 | 20 | 3 | 2.226 | 2.206 | A | B | A |
| Comparative Example 1-3 | 100 | 20 | 0 | 0 | 2 | 10 | 20 | 1 | 1.422 | 0.686 | B | A | A |

As shown in Table 1, the electronic component processing film of Example 1-1, in which terephthalic acid ester was used as a plasticizer for the adhesion layer and a reaction product of an aliphatic dicarboxylic acid and a glycol was used as a plasticizer for the substrate layer, exhibited a change rate of the SUS adhesion at 90 days after the preparation from the SUS adhesion at 2 days after the preparation being within ±20%, indicating favorable temporal stability in adhesion. Further, the pigment ejection after the expansion process from the substrate layer facing the expansion apparatus was suppressed by including a pigment with a maximum diameter of 10 μm in the substrate layer.

The electronic component processing film of Comparative Example 1-1, in which phthalic acid ester was used as a plasticizer for the adhesion layer and the substrate layer, exhibited a change rate of the SUS adhesion at 90 days after the preparation from the SUS adhesion at 2 days after the preparation being outside ±20%, indicating inferior temporal stability in adhesion. Further, the pigment ejection after the expansion process from the substrate layer facing the expansion apparatus was caused by including a pigment with a maximum diameter of 30 μm in the substrate layer.

The electronic component processing film of Comparative Example 1-2, in which a reaction product of an aliphatic dicarboxylic acid and a glycol was used as a plasticizer for the adhesion layer and the substrate layer, exhibited a change rate of the SUS adhesion at 90 days after the preparation from the SUS adhesion at 2 days after the preparation being within ±20%, indicating favorable temporal stability in adhesion. However, the interlayer adhesion was insufficient.

The electronic component processing film of Comparative Example 1-3, in which terephthalic acid ester was used as a plasticizer for the adhesion layer and the substrate layer, exhibited a change rate of the SUS adhesion at 90 days after the preparation from the SUS adhesion at 2 days after the preparation being outside ±20%, indicating inferior temporal stability in adhesion.

<Second Embodiment>

(Preparation of adhesive composition)

The materials shown in the following Table 2 were mixed at the amounts shown in Table 2 (parts by mass), thereby preparing a composition for adhesion layer.

As the substrate, the materials shown in Table 2 were used. The amount of the adhesive shown in Table 2 is the amount of the solid component included in the adhesive.

The details of the materials shown in Table 2 are as follows.

Adhesive 1: acrylic adhesive (Tohpe Corporation, XE-2644, solid content: 12% by mass, a copolymer of butyl acrylate by 80 to 90% by mass and acrylonitrile by 10 to 20% by mass)

Adhesive 2: acrylic adhesive (Nagase ChemteX Corporation, TEISANRESIN, WS-023DR, dissolved in toluene, solid content: 17% by mass, a copolymer of butyl acrylate by 60 to 70% by mass, ethyl acrylate by 10 to 20% by mass and acrylonitrile by 10 to 20% by mass)

Plasticizer 1: bis(2-ethylhexyl) terephthalate, Adeka Corporation, D-810, solid content: 100% by mass

Plasticizer 2: bis(2-ethylhexyl) phthalate, Godo Co., Ltd., DOP, solid content: 100% by mass

Crosslinking agent: polyfunctional isocyanate (Nippon Polyurethane Industry Co., Ltd., CORONATE L, solid content: 75% by mass

Solvent: methyl ethyl ketone

Substrate 1: polyvinyl chloride film (thickness: 80 μm), including bis(2-ethylhexyl) phthalate by 38% by mass and a pigment (ultramarine blue, maximum particle diameter: 30 μm) by 0.5% by mass with respect to the total substrate.

Substrate 2: polyvinyl chloride film (thickness: 80 μm), including adipic acid-based polyester by 44% by mass and a pigment (phthalocyanine blue, maximum particle diameter: 10 μm) by 0.5% by mass with respect to the total substrate

(Preparation of electronic component processing film)

To a surface of a polyethylene terephthalate film (thickness: 38 μm), treated with a releasing agent, the composition for adhesion layer was applied so as to form an adhesion layer with a thickness in a dried state shown in Table 2, and dried.

Subsequently, the adhesion-layer side of the polyethylene terephthalate film was attached to a substrate at room temperature (25°C), and the adhesion layer was transferred to the substrate by applying a pressure with a rubber roll, thereby preparing an electronic component processing film having a substrate layer and an adhesion layer for Examples 2-1 to 2-6 and Comparative Examples 2-1 to 2-4.

(Evaluation of expandability)

The tensile strength and tensile elongation rate of the electronic component processing film of Example 2-1, using substrate 2, measured by the methods as described above were 26.5 MPa and 339%, respectively, indicating favorable expandability.

The tensile strength and tensile elongation rate of the electronic component processing film of Example 2-6, using substrate 1, measured by the methods as described above were 27.5 MPa and 347%, respectively, indicating favorable expandability.

(Evaluation of SUS adhesion and tackiness)

The SUS adhesion and the tackiness of the electronic component processing film were measured by the methods as described above. The results are shown in Table 2.

(Evaluation of chip dropping)

Chips (size: 1 mm × 1 mm) that had been diced on a dicing film were transferred from the dicing film to the electronic component processing film by attaching the adhesion layer to the chips. In this state, the electronic component processing film was expanded at 60°C, and a state of chip dropping was evaluated by the following criteria.

A: there is almost no chip dropping.
B: there is chip dropping which is not problematic in practical use.
C: there is chip dropping which is problematic in practical use.

(Evaluation of pigment ejection)

The electronic component processing film was expanded on an expansion apparatus at 60°C, such that the maximum diameter after the expansion was twice as large as the original maximum diameter. Thereafter, in order to see if a pigment was ejected from the substrate layer, a surface of the substrate layer, which had been contacting the expansion apparatus, was wiped with a white cloth three times, and the existence or non-existence of the pigment on the white cloth was determined with a microscope.

As a result, attachment of the pigment to the white cloth was observed in the electronic component processing film of Example 2-6, including a pigment having a maximum particle diameter of 30 $\mu$m, but was not observed in the other electronic component processing films. These results show that the ejection of a pigment is effectively suppressed by including a pigment having a maximum particle diameter of 25 $\mu$m or less in the substrate layer.

[Table 2]

| | Substrate | Composition for adhesion layer | | | | | | | Evaluation results | | |
|---|---|---|---|---|---|---|---|---|---|---|---|
| | | Adhesive | | Plasticizer | | Crosslinking agent | Solvent | Adhesion layer thickness [μm] | SUS adhesion [N/25mm] | Tackiness [gf] | Chip dropping |
| | | 1 | 2 | 1 | 2 | | | | | | |
| Example 2-1 | 2 | 100 | 0 | 0 | 0 | 2 | 10 | 20 | 3.214 | 112 | A |
| Example 2-2 | 2 | 100 | 0 | 10 | 0 | 2 | 10 | 20 | 2.069 | 84 | A |
| Example 2-3 | 2 | 100 | 0 | 15 | 0 | 2 | 10 | 15 | 1.883 | 80 | A |
| Example 2-4 | 2 | 100 | 0 | 15 | 0 | 2 | 10 | 20 | 2.143 | 85 | A |
| Example 2-5 | 2 | 100 | 0 | 20 | 0 | 2 | 10 | 20 | 1.348 | 81 | A |
| Example 2-6 | 1 | 100 | 0 | 0 | 30 | 2 | 10 | 20 | 1.411 | 42 | A |
| Comparative Example 2-1 | 2 | 100 | 0 | 30 | 0 | 2 | 10 | 20 | 1.008 | 66 | B |
| Comparative Example 2-2 | 2 | 100 | 0 | 30 | 0 | 7 | 10 | 20 | 0.986 | 65 | B |
| Comparative Example 2-3 | 2 | 0 | 100 | 30 | 0 | 1 | 10 | 10 | 2.854 | 36 | B |
| Comparative Example 2-4 | 2 | 0 | 100 | 30 | 0 | 5 | 10 | 10 | 2.550 | 18 | C |

As shown in Table 2, the electronic component processing films of Examples 2-1 to 2-6, having a tackiness of 40 gf or more and a SUS adhesion of 1.1 N/25 mm or more, exhibited suppressed chip dropping when the film is expanded, as compared with the electronic component processing films of Comparative Examples 2-1 to 2-4, having a tackiness of less than 40 gf or a SUS adhesion of less than 1.1 N/25 mm.

<Third Embodiment>

(Preparation of adhesive composition)

The materials shown in the following Table 3 were mixed at the amounts shown in Table 3 (parts by mass), thereby preparing a composition for adhesion layer.
As the substrate, the materials shown in Table 3 were used. The amount of the adhesive shown in Table 3 is the amount of the solid component included in the adhesive.

The details of the materials shown in Table 3 are as follows.

Adhesive 1: acrylic adhesive (Tohpe Corporation, XE-2644, solid content: 12% by mass, a copolymer of butyl acrylate by 80 to 90% by mass and acrylonitrile by 10 to 20% by mass)
Adhesive 2: acrylic adhesive (Nagase ChemteX Corporation, TEISANRESIN, WS-023DR, dissolved in toluene, solid content: 17% by mass, a copolymer of butyl acrylate by 60 to 70% by mass, ethyl acrylate by 10 to 20% by mass and acrylonitrile by 10 to 20% by mass)
Plasticizer: bis(2-ethylhexyl) terephthalate, Adeka Corporation, D-810, solid content: 100% by mass
Crosslinking agent: polyfunctional isocyanate (Nippon Polyurethane Industry Co., Ltd., CORONATE L, solid content: 75% by mass
Solvent: methyl ethyl ketone
Substrate: polyvinyl chloride film (thickness: 80 $\mu$m), including adipic acid-based polyester (Mw: approximately 2,000) by 44% by mass and a pigment (phthalocyanine blue, maximum particle diameter: 10 $\mu$m) by 0.5% by mass with respect to the total substrate

(Preparation of electronic component processing film)

To a surface of a polyethylene terephthalate film (thickness: 38 $\mu$m), treated with a releasing agent, the composition for adhesion layer was applied so as to form an adhesion layer with a thickness in a dried state shown in Table 3, and dried.
Subsequently, the adhesion-layer side of the polyethylene terephthalate film was attached to a substrate at room temperature (25°C), and the adhesion layer was transferred to the substrate by applying a pressure with a rubber roll, thereby preparing an electronic component processing film having a substrate layer and an adhesion layer for Examples 3-1 to 3-4 and Comparative Examples 3-1 to 3-6.

(Evaluation of expandability)

The tensile strength and tensile elongation rate of the electronic component processing film of Example 3-2 measured by the methods as described above were 26.5 MPa and 339%, respectively, indicating favorable expandability.

(Evaluation of SUS adhesion)

The SUS adhesion of the electronic component processing film of the Examples and the Comparative Examples was measured by the methods as described above. The results are shown in Table 3.

(Evaluation of chip dropping)

Chips (size: 1 mm $\times$ 1 mm) that had been diced on a dicing film were transferred from the dicing film to the electronic component processing film by attaching the adhesion layer to the chips. In this state, the electronic component processing film was expanded at 60°C, and a state of chip dropping was evaluated by the following criteria.

A: there is no chip dropping.

B: there is chip dropping.

[Table 3]

|  | Adhesive | | Plasticizer | Crosslinking agent | Adhesion layer thickness [μm] | SUS adhesion [N/25mm] | Chip dropping |
|  | 1 | 2 |  |  |  |  |  |
|---|---|---|---|---|---|---|---|
| Example 3-1 | 100 | 0 | 20 | 2 | 23 | 1.515 | A |
| Example 3-2 | 100 | 0 | 20 | 2 | 20 | 1.507 | A |
| Example 3-3 | 100 | 0 | 20 | 2 | 17 | 1.455 | A |
| Example 3-4 | 100 | 0 | 20 | 2 | 14 | 1.176 | A |
| Comparative Example 3-1 | 100 | 0 | 20 | 2 | 11 | 1.054 | B |
| Comparative Example 3-2 | 100 | 0 | 20 | 2 | 4 | 0.848 | B |
| Comparative Example 3-3 | 0 | 100 | 0 | 5 | 10 | 3.114 | B |
| Comparative Example 3-4 | 0 | 100 | 30 | 1 | 10 | 2.854 | B |
| Comparative Example 3-5 | 0 | 100 | 0 | 5 | 5 | 2.572 | B |
| Comparative Example 3-6 | 0 | 100 | 0 | 5 | 3 | 2.450 | B |

As shown in Table 3, the electronic component processing films of the Examples, in which the thickness of the adhesion layer was 12 μm or more, did not cause chip dropping. The electronic component processing films of the Comparative Examples, in which the thickness of the adhesion layer was less than 12 μm, caused chip dropping even if the SUS adhesion was high.

**Claims**

1. An electronic component processing film, comprising an adhesion layer and a substrate layer, the adhesion layer comprising a terephthalic acid ester, and the substrate layer comprising a reaction product of an aliphatic dicarboxylic acid and a glycol.

2. The electronic component processing film according to claim 1, wherein the adhesion layer comprises an acrylic adhesive.

3. The electronic component processing film according to claim 1 or claim 2, wherein the substrate layer comprises polyvinyl chloride.

4. The electronic component processing film according to any one of claim 1 to claim 3, wherein the substrate layer comprises a colorant, and the colorant has a maximum particle diameter of 25 μm or less, wherein the maximum particle diameter is determined as described in the description.

5. The electronic component processing film according to any one of claim 1 to claim 4, having a tensile strength of 20 MPa or more, wherein the tensile strength is measured as described in the description.

6. The electronic component processing film according to any one of claim 1 to claim 5, having a tensile elongation rate of 200% or more, wherein the tensile elongation is measured as described in the description.

7. A method for processing an electronic component, the method comprising expanding the electronic component processing film according to any one of claim 1 to claim 6, on which diced electronic components are disposed.

8. The method for processing an electronic component according to claim 7, the method comprising, after expanding the electronic component processing film, processing the electronic components on the electronic component processing film.

**Patentansprüche**

1. Folie zur Verarbeitung elektronischer Bauteile, umfassend eine Haftschicht und eine Substratschicht, wobei die Haftschicht einen Terephthalsäureester umfasst und die Substratschicht ein Reaktionsprodukt einer aliphatischen Dicarbonsäure und eines Glykols umfasst.

2. Folie zur Verarbeitung elektronischer Bauteile nach Anspruch 1, wobei die Haftschicht ein acrylisches Haftmittel umfasst.

3. Folie zur Verarbeitung elektronischer Bauteile nach Anspruch 1 oder Anspruch 2, wobei die Substratschicht Polyvinylchlorid umfasst.

4. Folie zur Verarbeitung elektronischer Bauteile nach einem der Ansprüche 1 bis 3, wobei die Substratschicht ein Färbemittel umfasst und das Färbemittel einen maximalen Teilchendurchmesser von 25 $\mu$m oder weniger aufweist, wobei der maximale Teilchendurchmesser wie in der Beschreibung beschrieben bestimmt wird.

5. Folie zur Verarbeitung elektronischer Bauteile nach einem der Ansprüche 1 bis 4 mit einer Zugfestigkeit von 20 MPa oder mehr, wobei die Zugfestigkeit wie in der Beschreibung beschrieben gemessen wird.

6. Folie zur Verarbeitung elektronischer Bauteile nach einem der Ansprüche 1 bis 5 mit einer Zugdehnungsrate von 200 % oder mehr, wobei die Zugdehnung wie in der Beschreibung beschrieben gemessen wird.

7. Verfahren zur Verarbeitung eines elektronischen Bauteils, das Verfahren umfassend das Expandieren der Folie zur Verarbeitung elektronischer Bauteile nach einem der Ansprüche 1 bis 6 auf der vereinzelte elektronische Bauteile angeordnet sind.

8. Verfahren zur Verarbeitung eines elektronischen Bauteils nach Anspruch 7, wobei das Verfahren nach dem Expandieren der Folie zur Verarbeitung elektronischer Bauteile das Verarbeiten der elektronischen Bauteile auf der Folie zur Verarbeitung elektronischer Bauteile umfasst.

**Revendications**

1. Film de traitement de composant électronique, comprenant une couche d'adhérence et une couche de substrat, la couche d'adhérence comprenant un ester d'acide téréphtalique, et la couche de substrat comprenant un produit de réaction d'un acide dicarboxylique aliphatique et d'un glycol.

2. Film de traitement de composant électronique selon la revendication 1, dans lequel la couche d'adhérence comprend un adhésif acrylique.

3. Film de traitement de composant électronique selon la revendication 1 ou la revendication 2, dans lequel la couche de substrat comprend du chlorure de polyvinyle.

4. Film de traitement de composant électronique selon l'une quelconque des revendications 1 à 3, dans lequel la couche de substrat comprend un colorant, et le colorant présente un diamètre de particule maximum de 25 pm ou moins, dans lequel le diamètre de particule maximum est déterminé tel que décrit dans la description.

5. Film de traitement de composant électronique selon l'une quelconque des revendications 1 à 4, présentant une résistance à la traction de 20 MPa ou plus, dans lequel la résistance à la traction est mesurée tel que décrit dans la description.

6. Film de traitement de composant électronique selon l'une quelconque des revendications 1 à 5, présentant un taux d'allongement en traction de 200 % ou plus, dans lequel l'allongement en traction est mesuré tel que décrit dans la description.

7. Procédé de traitement d'un composant électronique, le procédé comprenant l'expansion du film de traitement de composant électronique selon l'une quelconque des revendications 1 à 6, sur lequel sont disposés des composants électroniques découpés en dés.

8. Procédé de traitement d'un composant électronique selon la revendication 7, le procédé comprenant, après expansion du film de traitement de composant électronique, le traitement des composants électroniques sur le film de traitement de composant électronique.

FIG. 1

unit : mm

**EP 4 019 245 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018216621 A
- WO 2017150017 A1
- JP 2017132940 A